Europäisches Patentamt

European Patent Office

Office européen des brevets

(19)

(11) Veröffentlichungsnummer: **0 156 021**
**A2**

(12) ## EUROPÄISCHE PATENTANMELDUNG

(21) Anmeldenummer: **84115590.6**

(22) Anmeldetag: **17.12.84**

(51) Int. Cl.⁴: **H 03 L 7/08**

(30) Priorität: **27.03.84 DE 3411244**

(43) Veröffentlichungstag der Anmeldung:
**02.10.85 Patentblatt 85/40**

(84) Benannte Vertragsstaaten:
**AT BE CH DE FR IT LI NL**

(71) Anmelder: **Siemens Aktiengesellschaft
Berlin und München Wittelsbacherplatz 2
D-8000 München 2(DE)**

(72) Erfinder: **Meyer, Fritz, Dr.-Ing.
Wifostrasse 5
D-8034 Germering(DE)**

(54) **Phasenregelkreis.**

(57) Phasenregelkreise für Signalfrequenzen von etwa 100 MHz unter Verwendung eines Ringmodulators sind bekannt. Bei Verwendung eines aktiven Schleifenfilters mit einem Operationsverstärker können sich Schwierigkeiten ergeben, falls nicht eine positive und eine negative Betriebsspannung zur Verfügung stehen. Erfindungsgemäß wird ein Phasenregelkreis vorgeschlagen, der einen Ringmodulator mit Gegentaktausgang enthält, bei dem die beiden Gegentaktausgänge über ein symmetrisches Filter und eine symmetrische Anordnung zur Bezugspotentialüberlagerung mit einem symmetrischen Schleifenfilter und über dieses mit einem Verstärker mit Gegentaktaussteuerung verbunden sind.

Erfindungsgemäße Phasenregelkreise werden insbesondere bei der Erzeugung des Taktes für Regeneratoren für digitale Signale eingesetzt.

FIG 1

Siemens Aktiengesellschaft
Berlin und München

Unser Zeichen
VPA 84 P 1 2 4 8 E

## Phasenregelkreis

Die Erfindung betrifft einen Phasenregelkreis entsprechend dem Oberbegriff des Patentanspruchs 1.

Die Verwendung von Ringmodulatoren als Phasenvergleicher in Phasenregelkreisen ist bekannt. Die Verwendung von Ringmodulatoren bietet dabei eine Reihe von Vorteilen, neben der hohen Genauigkeit ist insbesondere die Eignung für sehr hohe Frequenzen von wenigstens 100 MHz von besonderer Bedeutung, außerdem kann die Abhängigkeit des Ringmodulatorausgangssignals von der Oszillatoramplitude sehr weit verringert werden. Bei der Verwendung eines Ringmodulators in einer Phasenregelschleife treten aber auch eine Reihe von Problemen auf, die sich insbesondere daraus ergeben, daß das Ausgangssignal des Phasenvergleichers positiv oder negativ sein kann. So ist bei einem nachgeschalteten aktiven Schleifenfilter darauf zu achten, daß dies für bipolare Aussteuerung ausgelegt ist. Bei Verwendung eines passiven Schleifenfilters wird in der Regel ein Verstärker nachgeschaltet, der in diesem Falle für bipolare Aussteuerungen ausgelegt sein muß. Als Verstärker wird dabei in der Regel ein Operationsverstärker verwendet, der eine positive und eine negative Betriebsspannung benötigt. Eine derartige Lösung wird unmöglich, wenn nur eine einseitig geerdete Versorgungsspannung zur Verfügung steht, da dann keine Aussteuerung des Operationsverstärkers nach positiven und nach negativen Potentialen möglich ist.

Ah 1 Seu / 26.3.1984

Das Problem der bipolaren Aussteuerung kann dadurch gelöst werden, daß das Ausgangssignal des Phasenvergleichers beispielsweise mittels einer Zenerdiode um ein Gleichpotential verschoben wird, so daß am nachgeschalteten Verstärker nur noch ein Eingangssignal mit einer Polarität auftritt. Bei der Erzeugung eines derartigen Bezugspotentials ergeben sich aber neue Schwierigkeiten, da dieses durch einen Kondensator nach Masse stabilisiert und vor Einkopplungen unerwünschter Wechselspannungen geschützt werden muß. Zusammen mit den ohnehin vorhandenen Widerständen ergibt sich dadurch aber ein RC-Glied, das das Übertragungsverhalten im Regelkreis insbesondere zu tiefen Frequenzen hin in unerwünschter Weise verändert. Außerdem ist die erwünschte konstante Kopplung im tiefen Frequenzbereich bis zum Gleichstrom nicht mehr vorhanden. Die Verwendung einer Zenerdiode hat weiterhin den Nachteil, daß eine hohe Alterungsstabilität der Zenerspannung gefordert werden muß, da sich Schwankungen des Bezugspotentials beispielsweise in Form einer Gleichspannungsdrift wie ein Störsignal im Regelkreis auswirken und zu einem statischen Phasenfehler führen.

Die Aufgabe bei der vorliegenden Erfindung besteht also darin, einen Phasenregelkreis der eingangs erwähnten Art zu entwickeln, der nur eine Betriebsspannung benötigt, keinerlei Schwierigkeiten bei der Erzeugung eines Bezugspotentials hinsichtlich der Entkopplung bietet, keine Spannungsstabilisierung mittels Zenerdiode benötigt und auch im Frequenzbereich von mehreren 100 MHz verwendbar ist.

Erfindungsgemäß wird die Aufgabe durch einen Phasenregelkreis der eingangs erwähnten Art dadurch gelöst, daß ein Ringmodulator mit Gegentaktausgang vorgesehen ist, daß jeder der beiden Gegentaktausgänge über ein, die Eingangssignale und deren Harmonische des Ringmodulators sperrendes symmetrisches Hochfrequenzfilter sowohl mit einer symmetrischen Anordnung zur Bezugspotentialüberlagerung als auch mit einem symmetrischen Schleifenfilter verbunden ist und daß die Ausgänge des symmetrischen Schleifenfilters jeweils getrennt mit Eingängen eines Verstärkers mit Gegentaktaussteuerung verbunden sind, an dessen Ausgängen ein Steuersignal für den spannungsgesteuerten Oszillator (VCO) des Phasenregelkreises entnehmbar ist.

Von besonderem Vorteil beim erfindungsgemäßen Phasenregelkreis ist die Möglichkeit, durch den weitgehend symmetrischen Aufbei eine hohe Sicherheit gegen Störungen und damit gegen unerwünschte Phasenschwankungen des erzeugten Taktsignals erreichen zu können.

Bevorzugte Weiterbildungen des erfindungsgemäßen Phasenregelkreises sind in den Patentansprüchen 2 bis 9 näher erläutert.

Die Erfindung soll im folgenden anhand der Zeichnung näher erläutert werden.

In der Zeichnung zeigt

Fig. 1 die Prinzipschaltung eines Phasenregelkreises und

Fig. 2 den detaillierten Aufbau eines derartigen Phasenregelkreises nach der Erfindung unter Verzicht auf die Darstellung des spannungsgesteuerten Oszillators.

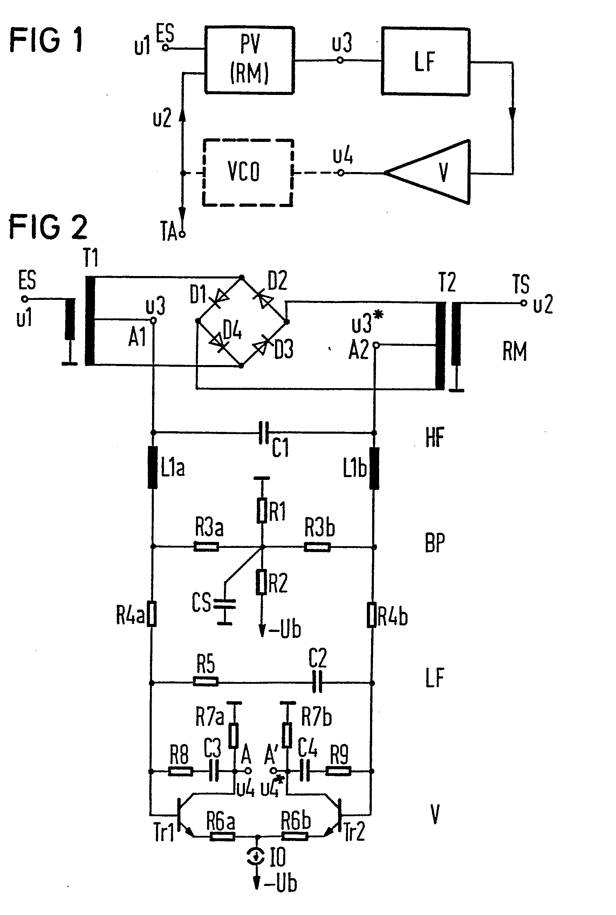

In der Fig. 1 ist mit ES der Eingang des Phasenregelkreises bezeichnet, an dem die Empfangsspannung u1 ansteht. Mit diesem Eingang ist der eine Anschluß eines Phasenvergleichers verbunden, der im vorliegenden Falle

**0156021**

mittels eines Ringmodulators realisiert ist und an dessen anderen Eingangsanschluß das örtlich erzeugte Taktsignal u2 ansteht. Aus dem Phasenvergleich beider Signale ergibt sich eine Gleichspannung u3 am Ausgang des Phasenvergleichers PV, die der Phasendifferenz beider Eingangssignale proportional ist. Der Gleichspannung u3 sind hochfrequente Störsignale, beispielsweise die Eingangssignale, überlagert, die durch das angeschlossene Schleifenfilter LF mit Tiefpaßcharakteristik unterdrückt werden. Das Ausgangssignal des Schleifenfilters LF wird in dem nachgeschalteten gleichspannungsgekoppelten Verstärker V so weit verstärkt, daß es als Stellspannung u4 das Nachstimmen des spannungsgesteuerten Oszillators VCO bewirken kann. Das Ausgangssignal des Oszillators ist das örtlich erzeugte Taktsignal, es steht am Taktsignalausgang TA beispielsweise einem angeschlossenen Regenerator für digitale Signale zur Verfügung.

In der Fig. 2 sind der Phasenvergleicher PV, das Schleifenfilter LF und der Verstärker V gegenüber der Fig. 1 detaillierter dargestellt. Mit ES ist wiederum der Eingang für die empfangenen dgitalen Signale bezeichnet, die mit der Spannung u1 auftreten und an die Primärwicklung eines ersten Übertragers T1 des als Phasenvergleicher dienenden Ringmodulators RM abgegeben werden. Der Übertrager T1 enthält eine mittelangezapfte Sekundärwicklung, deren einer äußerer Anschluß mit der Anode einer ersten Diode D1 und der Katode einer zweiten Diode D2 verbunden ist. Der andere äußere Anschluß der Sekundärwicklung ist mit der Anode einer dritten Diode D3 und der Katode einer vierten Diode D4 verbunden. Der Ringmodulator RM enthält einen zweiten Übertrager T2, dessen Primärwicklung mit dem Taktsignaleingang TS verbunden ist und der damit das örtlich erzeugte Taktsignal u2 erhält. Der Übertrager T2 umfaßt ebenfalls eine mittelangezapfte Sekundärwicklung, wobei deren einer Anschluß mit der Anode der zweiten Diode D2 und der Katode der dritten Diode D3 verbunden ist, während an den anderen Anschluß die Katode der ersten Diode D1 und die Anode der vierten Diode D4 angeschlossen sind. Die Ausgangssignale $u3$, $u3^*$ des Ringmodulators treten an den Mittelanzapfungen der beiden Sekundärwicklungen auch als Gegentaktsignale auf. Diese Gegentaktsignale enthalten im eingerasteten Zustand des Regelkreises eine Gleichspannungskomponente, die der Phasendifferenz der gleichfrequenten Eingangssignale $u1$, $u2$ proportional ist, außerdem enthält das Signal $u3$ bzw. $u3^*$ einen Wechselspannungsanteil mit einer Frequenz gleich der doppelten Frequenz der Eingangssignale $u1$ bzw. $u2$. Für den Regelvorgang sind nur die Gleichspannungskomponente und die relativ niederfrequenten Anteile der Regelspannung, die bei Einschwingvorgängen auftreten, von Bedeutung. Zur Unterdrückung der Wechselspannungsanteile höherer Frequenz ist ein HF-Filter HF vorgesehen, es enthält einen ersten Kondensator C1, der mit den Ausgangsanschlüssen des Ringmodulators verbunden ist. Außerdem sind als HF-Drosseln eine erste und eine zweite Induktivität L1a, L1b, vorgesehen, deren einer Anschluß mit jeweils einem Anschluß des ersten Kondensators C1 verbunden ist. An den anderen Anschluß dieser Induktivitäten ist eine Anordnung zur Bezugspotentialüberlagerung BP angeschlossen. Zu diesem Zweck sind mit dem zweiten Anschluß der Induktivitäten L1a, L1b jeweils Koppelwiderstände R3a, R3b verbunden, deren andere Anschlüsse miteinander, über einen ersten Widerstand R1 mit Bezugspotential und über einen zweiten Widerstand R2 mit der Betriebsspannung -Ub verbunden sind. Dem ersten Widerstand R1 ist ein Siebkondensator Cs parallelgeschaltet, der zur Siebung und Entkopplung der mittels des Spannungsteilers aus erstem und zweitem Widerstand und Betriebsspannung erzeugtem Bezugspotential dient.

0156021

An die Anordnung BP zur Bezugspotentialüberlagerung
schließt sich das symmetrische Schleifenfilter LF an,
das Vorwiderstände R4a, R4b enthält, die jeweils
getrennt mit den zweiten Anschlüssen der Induktivitäten
L1a, L1b verbunden sind. Die anderen Anschlüsse dieser
Widerstände sind über eine Reihenschaltung aus einem
zweiten Kondensator und einem fünften Widerstand R5
miteinander verbunden, außerdem sind an die anderen
Anschlüsse der Vorwiderstände die Eingänge des Gegentaktverstärkers V angeschlossen.

Der Verstärker V ist als emittergekoppelter Gegentaktverstärker mit den beiden Transistoren Tr1, Tr2 aufgebaut. Die Emitteranschlüsse dieser Transistoren sind
über jeweils einen Emitterwiderstand R6a, R6b mit einer
Stromquelle für den Emitterstrom Io verbunden. Die
Basisanschlüsse dieser Transistoren sind jeweils getrennt mit dem zweiten Anschluß jeweils eines der
Vorwiderstände R4a, R4b des Schleifenfilters LF verbunden. Die Kollektoranschlüsse der Transistoren
stellen die Ausgangsanschlüsse A bzw. A' des Verstärkers
dar, an denen eine Spannung u4 bzw. die um $180^o$ phasenverschobene Spannung $u4^*$ entnehmbar ist, die zur Nachsteuerung des spannungsgesteuerten Oszillators VCO
dient. Die Kollektoranschlüsse sind außerdem über
Kollektorwiderstände R7a, R7b mit Bezugspotential verbunden. Die Verstärkung des Verstärkers V kann durch
Wahl der Emitterwiderstände R6a, R6b und der Kollektorwiderstände R7a, R7b eingestellt werden.

Zusammen mit den Vorwiderständen R4a, R4b des Schleifenfilters LF kann unter Wegfall des RC-Gliedes R5, C2
mittels des Verstärkers V ein aktives Schleifenfilter
aufgebaut werden, in dem zwischen die Kollektor- und
die Basisanschlüsse des ersten und des zweiten Transistors ein RC-Glied R8, C3 bzw. R9, C4 eingeschaltet
werden, wobei der achte bzw. der neunte Widerstand den
fünften Widerstand und der dritte bzw. vierte Kondensator
C3, C4 den zweiten Kondensator C2 ersetzen.

Für eine enge thermische Kopplung zur Verringerung der temperaturabhängigen Gleichspannungsdrifts und zur Sicherung symmetrischer elektrischer Eigenschaften können die Transistoren Tr1, Tr2 in ein gemeinsames Gehäuse eingebaut sein. Besonders vorteilhafte Eigenschaften ergeben sich, wenn die Transistorsysteme dabei von benachbarten Stellen der gleichen Halbleiterscheibe stammen und dadurch in der Herstellung gleichen Bedingungen unterworfen waren.

Bei vielen Anwendungen ist es wünschenswert, die temperaturabhängige Frequenzdrift des spannungsgesteuerten Oszillators zu verringern. Zu diesem Zweck kann der Emitterstrom des Verstärkers V temperaturabhängig ausgeführt werden, so daß über eine zusätzliche Gleichspannungskomponente zur Stellspannung $u4$ bzw. $u4^{\textsf{x}}$ die Frequenzdrift des Oszillators kompensiert wird.

9 Patentansprüche
2 Figuren

Patentansprüche

1. Phasenregelkreis zur Erzeugung eines Taktsignals in Abhängigkeit vom Takt eines Empangssignals mit einem Ringmodulator als Phasenvergleicher, einem nachgeschalteten Schleifenfilter und einem spannungsgesteuerten Oszillator, dessen Ausgang mit einem Eingang des Ringmodulators verbunden ist, d a d u r c h g e k e n n - z e i c h n e t , daß ein Ringmodulator (RM) mit Gegentaktausgang (A1, A2) vorgesehen ist, daß jeder der beiden Gegentaktausgänge (A1, A2) über ein, die Eingangssignale und deren Harmonische des Ringmodulators sperrendes symmetrisches Hochfrequenzfilter (HF) sowohl mit einer symmetrischen Anordnung zur Bezugspotentialüberlagerung (BP) als auch mit einem symmetrischen Schleifenfilter (LF) verbunden ist und daß die Ausgänge des symmetrischen Schleifenfilters (LF) jeweils getrennt mit Eingängen eines Verstärkers (V) mit Gegentaktaussteuerung verbunden sind, an dessen Ausgängen (A,A') ein Steuersignal für den spannungsgesteuerten Oszillator (VCO) des Phasenregelkreises entnehmbar ist.

2. Phasenregelkreis nach Patentanspruch 1, d a d u r c h g e k e n n z e i c h n e t , daß der Ringmodulator (RM) einen ersten Übertrager (T1) enthält, dessen Primärwicklung auf der einen Seite mit Bezugspotential und auf der anderen Seite mit dem Eingang (ES) für ein Empfangssignal verbunden ist, daß der eine äußere Anschluß der Sekundärwicklung des ersten Übertragers (T1) mit dem Anodenanschluß einer ersten Diode (D1) und dem Kathodenanschluß einer zweiten Diode (D2) verbunden ist, daß der andere äußere Anschluß der Sekundärwicklung mit der Anode einer dritten Diode (D3) und der Kathode einer vierten Diode (D4) verbunden ist, daß der Ringmodulator einen zweiten Übertrager (T2)

Ah 1 Seu / 26.3.1984

0156021

enthält, dessen Primärwicklung einseitig mit Bezugspotential und auf der anderen Seite mit dem zweiten
Phasenvergleichereingang (TS) für das Taktsignal verbunden
ist, daß der eine äußere Anschluß der Sekundärwicklung
mit der Anode der zweiten Diode (D2) und der Kathode
der dritten Diode (D3) verbunden ist, daß der
andere äußere Sekundärwicklungsanschluß mit der Kathode
der ersten Diode (D1) und der Anode der vierten Diode
(D4) verbunden ist, und daß die Mittelanzapfungen
der Sekundärwicklungen des ersten und des zweiten
Übertragers (T1, T2) die Gegentaktausgänge (A1, A2)
des Ringmodulators (RM) darstellen.

3. Phasenregelkreis nach Patentansprüchen 1 oder 2,
d a d u r c h   g e k e n n z e i c h n e t , daß
das mit den Gegentaktausgängen des Ringmodulators verbundene HF-Filter- (HF) eine erste Induktivität (L1a)
enthält, deren einer Anschluß mit dem einen Gegentaktausgang (A1) des Ringmodulators (RM) und außerdem
über einen ersten Kondensator C1 mit dem anderen Gegentaktausgang (A2) des Ringmodulators (RM) und mit dem einen
Anschluß einer zweiten Induktivität (L1b) verbunden
ist und daß die anderen Anschlüsse der Induktivitäten
(L1a, b)   jeweils getrennt mit der Anordnung zur
Bezugspotentialüberlagerung (BP) verbunden sind.

4. Phasenregelkreis nach einem der vorhergehenden
Patentansprüche, d a d u r c h   g e k e n n z e i c h -
n e t , daß die Anordnung zur Bezugspotentialüberlagerung
(BP) einen ersten Widerstand (R1) enthält, dessen einer
Anschluß mit Bezugspotential verbunden ist und zu dem
ein Siebkondensator (Cs) parallelgeschaltet ist, daß der
andere Anschluß des ersten Widerstandes (R1) über einen
zweiten Widerstand (R2) mit einer Betriebsspannungsquelle (-Ub) und außerdem über Koppelwiderstände
(R3a, R3b) mit den zweiten Anschlüssen der Induktivitäten
(L1a, b) des HF-Filters (HF) verbunden ist.

5. Phasenregelkreis nach einem der vorhergehenden Ansprüche, d a d u r c h   g e k e n n z e i c h n e t , daß ein symmetrisches passives Schleifenfilter (LF) erster Ordnung vorgesehen ist, bei dem die zweiten Anschlüsse der Induktivitäten des vorgeschalteten HF-Filters (HF) jeweils getrennt über Vorwiderstände (R4a, R4b) mit der Reihenschaltung aus einem zweiten Kondensator (C2) und einem fünften Widerstand (R5) verbunden sind.

6. Phasenregelkreis nach einem der vorhergehenden Patentansprüche, d a d u r c h   g e k e n n z e i c h - n e t , daß mit den Vorwiderständen (R4a, R4b) des Schleifenfilters (LF) jeweils getrennt die Basisanschlüsse eines ersten und eines zweiten Transistors (Tr1, Tr2) des Verstärkers (V) verbunden sind, daß die Emitteranschlüsse beider Transistoren über jeweils einen vorgeschalteten Emitterwiderstand (R6a, R6b) mit einer Emitterstromquelle (Io) verbunden sind und daß die Kollektoranschlüsse beider Transistoren jeweils einen Ausgangsanschluß (A, A') für das Steuersignal des spannungsgesteuerten Oszillators darstellen und außerdem über Kollektorwiderstände (R7a, R7b) mit Bezugspotential verbunden sind.

7. Phasenregelkreis nach Patentanspruch 6, d a d u r c h   g e k e n n z e i c h n e t , daß die Kollektoranschlüsse der Transistoren (T1, T2) über Reihenschaltungen aus einem dritten Kondensator (C3) und einem achten Widerstand (R8) bzw. einem vierten Kondensator (C4) und einem neunten Widerstand (R9) mit dem Basisanschluß des jeweiligen Transistors (Tr1, Tr2) verbunden sind.

0156021

8. Phasenregelkreis nach Patentanspruch 6, d a - d u r c h  g e k e n n z e i c h n e t , daß die Transistoren (Tr1, Tr2) zur engen thermischen Kopplung in ein gemeinsames Gehäuse eingebaut sind.

9. Phasenregelkreis nach Patentanspruch 6, d a - d u r c h  g e k e n n z e i c h n e t , daß der Emitterstrom (Io) der Transistoren sich in Abhängigkeit von der Temperatur ändert.

FIG 1

FIG 2